# EUROPEAN PATENT APPLICATION

(11) **EP 1 698 904 A1**
(43) Date of publication of application: **06.09.2006**
(21) Application number: 04799624.4
(22) Date of filing: 11.11.2004
(51) Int. Cl.: G01R 1/06, G01R 1/067, G01R 1/073, H01L 21/66

(54) **CONDUCTIVE CONTACT HOLDER, CONDUCTIVE CONTACT UNIT AND PROCESS FOR PRODUCING CONDUCTIVE CONTACT HOLDER**

(30) Priority: 25.12.2003 JP 2003430400
(71) Applicant: NHK SPRING COMPANY LIMITED, Yokohama-shi, Kanagawa 236-0004 (JP)
(72) Inventor: SAITOU, Shinji;, ku, Yokohama-shi, Kanagawa 2360004; (JP); KAZAMA, Toshio;, a-gun, Nagano 3994301; (JP); NAGAYA, Mitsuhiro;, a-gun, Nagano 3994301; (JP)
(74) Representative: HOFFMANN EITLE
(86) International application number: PCT/JP2004/016763
(87) International publication number: WO 2005/064351

(57) **Abstract**

An electrically conductive contact holder (1) includes a supporting member (4) having a structure where a low thermal expansion supporting frame (15, 18) with a coefficient of linear expansion lower than that of a to-be-contacted member (8) and a high thermal expansion supporting frame (16, 17) with a coefficient of linear expansion higher than that of the to-be-contacted member (8) are laminated one on another. With the laminated structure, the coefficient of linear expansion of the entire supporting member (4) can be approximated to the coefficient of linear expansion of the to-be-contacted member (8). Thus, it is possible to suppress the occurrence of displacement between the electrically conductive contacts (2) and external connecting terminals (9) even under high temperature conditions.

## Description

### TECHNICAL FIELD

The present invention relates to a technique for a holder including a supporting member, with a contacting surface opposed to a terminal surface of a to-be-contacted member on which external connecting terminals are arranged, wherein a plurality of electrically conductive contacts are arranged on the contacting surface to correspond to the external connecting terminals and electrically connected to the external connecting terminals.

### BACKGROUND ART

Conventionally, an electrically conductive contact unit has been used to inspect a circuit structure of a semiconductor device formed on a silicon substrate or the like, and one for semiconductor wafer with a diameter of, for example, about 200 millimeters has been proposed (see, for example, Patent Literature 1). Such an electrically conductive contact unit has a structure that electrically conductive contacts electrically connected to all external connecting terminals provided in many semiconductor devices formed on a semiconductor wafer are arranged to correspond to an arrangement pattern of the external connecting terminals. With this structure, the electrically conductive contact unit can inspect all semiconductor devices formed on a semiconductor wafer simultaneously and also efficiently as compared to performing an inspection after semiconductor devices are cut out of a semiconductor wafer into chips.

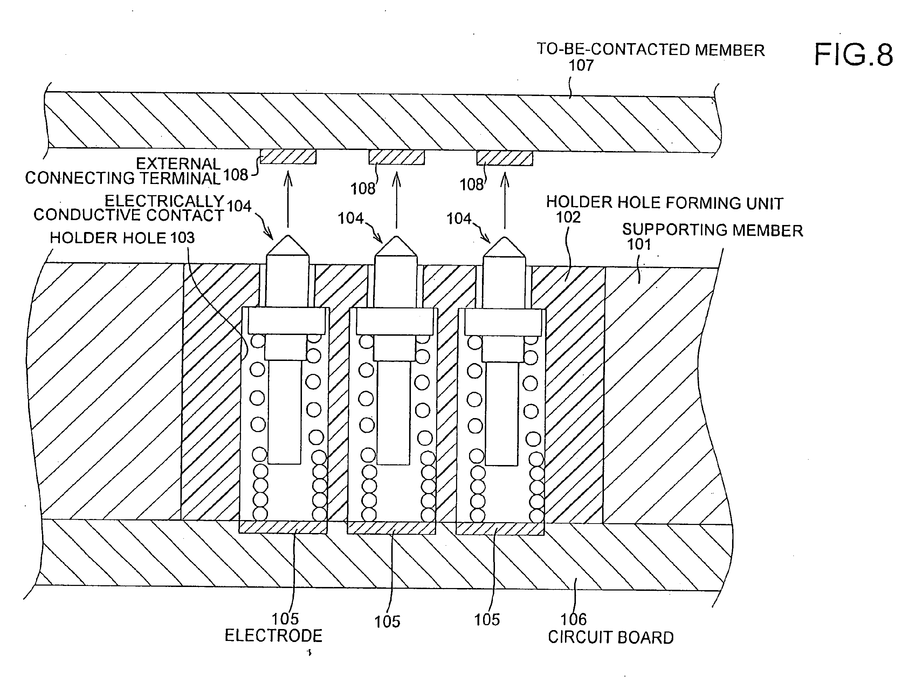

Fig. 8 is a sectional view of an example of a conventional electrically conductive contact unit. As shown in Fig. 8, the conventional electrically conductive contact unit includes a holder base plate 101 made of a metal material with an opening formed in a part to accommodate electrically conductive contacts, a holder hole forming unit 102 fitted in the opening formed in the holder base plate 101, electrically conductive contacts 104 accommodated in holder holes 103 formed in the holder hole forming unit 102, and a circuit board 106 having electrodes 105 electrically connected to the electrically conductive contacts 104.

As shown in Fig. 8, the electrically conductive contacts 104 are arranged so as to correspond to the arrangement of external connecting terminals 108 on a to-be-contacted member 107 such as a semiconductor wafer.
Each electrically conductive contact 104 has a spring member, and can be expanded and contracted in the axial direction when electrically connected to the external connecting terminal 108 on the to-be-contacted member 107. The electrically conductive contact unit shown in Fig. 8 is configured to use the electrically conductive contacts 104 to electrically connect the electrodes 105 of the circuit board 106 and the external connecting terminals 108 on the to-be-contacted member 107, thereby performing acceleration test or the like.

Patent Literature 1: Japanese Patent Application Laid-open No. 2000-188312(Page 2 and Fig. 3)

### DISCLOSURE OF INVENTION

### PROBLEM TO BE SOLVED BY THE INVENTION

However, since the conventional electrically conductive contact unit is provided with the holder base plate 101 formed of a metal material, there are various problems. First, in the conventional electrically conductive contact unit, it is difficult to cause the coefficient of linear expansion of the holder base plate 101 to match or approximate that of the to-be-contacted member 107.

In the case of, for example, a semiconductor wafer, the to-be-contacted member 107 is generally formed of a material containing silicon as a main component. On the other hand, the holder base plate 101 is formed of a metal material, as described above. The metal material generally has a different coefficient of linear expansion than silicon. Accordingly, when an inspection of the to-be-contacted member 107 is performed under a high temperature condition as in an acceleration test, displacement occurs between the electrically conductive contacts 104 and the external connecting terminals 108 due to the difference in coefficient of linear expansion therebetween, which makes it difficult to conduct an accurate inspection. Especially, since a metal material constituting the holder base plate 101 is selected considering such conditions as strength, options for the material are naturally limited. Therefore, it is difficult to form the holder base plate 101 with a coefficient of linear expansion approximating or matching that of the to-be-contacted member 107, without sacrificing strength or the like.

In the conventional electrically conductive contact unit, it is difficult to adjust the size of the opening formed in the holder base plate 101. That is, when the holder base plate 101 is formed of a metal material, the opening is formed by etching or the like. However, ordinary etching etches not only in the direction of thickness of the holder base plate 101 but also in the direction perpendicular to the thickness direction. So-called side etching, i.e., etching that proceeds in a direction perpendicular to a thickness direction, has a tendency that the amount of etching increases as the holder base plate 101 becomes thicker. Therefore, when etching is applied to the holder base plate 101 having a certain extent of thickness, the influence of the side etching is apparent, which causes displacement or the like in fitting the holder hole forming unit 102 into the holder base plate 101.

It is therefore an object of the present invention to provide an electrically conductive contact holder with a supporting member that can be formed in a simple manner, being capable of suppressing displacement that occurs for a to-be-contacted member according to temperature changes, and a manufacturing method thereof.

### MEANS FOR SOLVING PROBLEM

According to claim 1, to overcome the problem mentioned above and to achieve the objects, an electrically conductive contact holder comprises a supporting member to hold a plurality of electrically conductive contacts, with a contacting surface corresponding to a terminal surface of a to-be-contacted member, on which a plurality of external connecting terminals are arranged. The electrically conductive contacts are arranged on the contacting surface so as to be electrically connected to the external connecting terminals, and received in holder holes. The supporting member includes a high thermal expansion supporting frame with a coefficient of linear expansion higher than that of the to-be-contacted member, and a low thermal expansion supporting frame that is arranged adjacent to the high thermal expansion supporting frame in a direction normal to the contacting surface and has a coefficient of linear expansion lower than that of the to-be-contacted member.

According to claim 1 of the present invention, the supporting member has a laminated structure of the high thermal expansion supporting frame and the low thermal expansion supporting frame. Thus, a coefficient of linear expansion of the entire supporting member can be approximated to that of the to-be-contacted member as compared to the supporting member formed of only the high thermal expansion supporting frame or only the low thermal expansion supporting frame.

According to claim 2, in the electrically conductive contact holder according to the above invention, the high thermal expansion supporting frame and the low thermal expansion supporting frame are formed so that a coefficient of linear expansion of the supporting member, defined based upon the thickness in the normal direction and the coefficient of linear expansion of each of the high thermal expansion supporting frame and the low thermal expansion supporting frame, corresponds to the coefficient of linear expansion of the to-be-contacted member.

According to claim 2 of the present invention, the coefficient of the linear expansion of supporting member can be adjusted to that of the to-be-contacted member. Thus, the occurrence of displacement due to change in the surrounding temperature can be suppressed.

According to claim 3, in the electrically conductive contact holder according to the above invention, the supporting member is formed such that the distribution of the coefficient of linear expansion thereof in the normal direction to the contacting surface is symmetrical about a midplane.

According to claim 3 of the present invention, the supporting member is formed so that the distribution of the coefficient of linear expansion is symmetrical. Thus, the occurrence of warping can be suppressed.

According to claim 4, in the electrically conductive contact holder according to the above invention, the supporting member includes an opening at a region where the electrically conductive contacts are arranged, and a holder hole forming unit that is set in the opening to form the holder holes therein.

According to claim 5, an electrically conductive contact holder comprises a supporting member, and an holder hole forming unit that is set in an opening formed in the supporting member and includes a holder hole accommodating an electrically conductive contact electrically connected to an external connecting terminal provided on a to-be-contacted member. Any one of the supporting member and the holder hole forming unit has a coefficient of linear expansion higher than that of the to-be-contacted member, while the other has a coefficient of linear expansion lower than that of the to-be-contacted member.

According to claim 5 of the present invention, one of the supporting member and the holder hole forming unit has a coefficient of linear expansion higher than that of the to-be-contacted member, and the other has a coefficient of linear expansion lower than that of the to-be-contacted member. Thus, it is possible to realize an electrically conductive contact holder having a coefficient of linear expansion approximating that of the to-be-contacted member as a whole.

According to claim 6, in the electrically conductive contact holder according to the above invention, the supporting member has a structure where a plurality of plate members having different coefficients of linear expansion are laminated in the thickness direction thereof.

According to claim 7, an electrically conductive contact unit comprises electrically conductive contacts that are arranged on a contacting surface opposed to a to-be-contacted member so as to be electrically connected to external connecting terminals provided on the to-be-contacted member in use, a supporting member that includes a high thermal expansion supporting frame with a coefficient of linear expansion higher than that of the to-be-contacted member and a low thermal expansion supporting frame that is arranged adjacent to the high thermal expansion supporting frame in a direction normal to the contacting surface and has a coefficient of linear expansion lower that that of the to-be-contacted member, and a circuit board that is electrically connected to the electrically conductive contacts and generates an electric signal supplied to the to-be-contacted member.

According to claim 8, in the electrically conductive contact unit according to the above invention, the high thermal expansion supporting frame and the low thermal expansion supporting frame are formed so that a coefficient of linear expansion of the supporting member, defined based upon the thickness in the normal direction of each of the high thermal expansion supporting frame and the low thermal expansion supporting frame and the coefficient of linear expansion thereof, corresponds to the coefficient of linear expansion of the to-be-contacted member, and that the distribution of the coefficient of linear expansion thereof in the normal direction to the contacting surface is symmetrical about a midplane.

According to claim 9, an electrically conductive contact unit, comprises electrically conductive contacts that are arranged on a contacting surface opposed to a to-be-contacted member so as to be electrically connected to external connecting terminals provided on the to-be-contacted member in use, a holder hole forming unit where holder holes are formed to accommodate the electrically conductive contacts, a supporting member that supports the holder hole forming unit, and a circuit board that is electrically connected to the electrically conductive contacts and generates an electric signal supplied to the to-be-contacted member. The holder hole forming unit and the supporting member are formed so that one thereof has a coefficient of linear expansion higher than that of the to-be-contacted member, while the other has a coefficient of linear expansion lower than that of the to-be-contacted member.

According to claim 10, a method for manufacturing an electrically conductive contact holder including a supporting member formed by stacking a plurality of plate members in layers and a holder hole forming unit set in an opening formed in the supporting member, in which holder holes are formed to accommodate electrically conductive contacts that are electrically connected to external connecting terminals provided on a to-be-contacted member. The method comprises an opening forming step of forming openings in the respective plate members, a supporting member forming step of joining the plurality of the plate members formed with the openings in the thickness direction of the plate members to form the supporting member, a fixing step of fixing the holder hole forming unit to the inner surface of the opening of the supporting member formed, and a holder hole forming step of forming the holder holes in the holder hole forming unit.

According to claim 10 of the present invention, the plurality of plate members constituting the supporting member are joined together after openings are formed therein, respectively. Therefore, when an opening is formed by, for example, etching, the amount of side etching can be reduced.

According to claim 11, in the method for manufacturing an electrically conductive contact holder according to the above invention, the plate members are joined together by diffusion bonding, the holder hole forming unit is fixed by soldering, and the supporting member forming step and the fixing step are simultaneously conducted.

According to claim 11 of the present invention, the plate members are joined together by diffusion bonding, and the holder hole forming unit is fixed by soldering. Thus, it is possible to perform the supporting member forming step and the fixing step simultaneously under the same temperature condition, which reduces manufacturing costs.

### EFFECT OF THE INVENTION

In the electrically conductive contact holder according to the present invention, the supporting member has a laminated structure of the high thermal expansion supporting frame and the low thermal expansion supporting frame. Thus, a coefficient of linear expansion of the entire supporting member can be approximated to that of the to-be-contacted member as compared to the supporting member formed of only the high thermal expansion supporting frame or only the low thermal expansion supporting frame.

Besides, in the electrically conductive contact holder according to the present invention, the coefficient of the linear expansion of supporting member can be adjusted to that of the to-be-contacted member. Thus, the occurrence of displacement due to change in the surrounding temperature can be suppressed.

Further, in the electrically conductive contact holder according to the present invention, the supporting member is formed so that the distribution of the coefficient of linear expansion is symmetrical. Thereby, the occurrence of warping can be suppressed.

Still further, in the electrically conductive contact holder according to the present invention, one of the supporting member and the holder hole forming unit has a coefficient of linear expansion higher than that of the to-be-contacted member, and the other has a coefficient of linear expansion lower than that of the to-be-contacted member. Thus, it is possible to realize an electrically conductive contact holder having a coefficient of linear expansion approximating that of the to-be-contacted member as a whole.

In the method for manufacturing an electrically conductive contact holder according to the present invention, the plurality of plate members constituting the supporting member are joined together after openings are formed therein, respectively. Therefore, when an opening is formed by, for example, etching, the amount of side etching can be reduced.

Further, in the method for manufacturing an electrically conductive contact holder according to the present invention, the plate members are joined together by diffusion bonding and the holder hole forming unit is fixed by soldering. Thus, it is possible to perform the supporting member forming step and the fixing step simultaneously under the same temperature condition, which reduces manufacturing costs.

### BRIEF DESCRIPTION OF DRAWINGS

[Fig. 1] Fig. 1 is a plan view of an electrically conductive contact unit according to an embodiment.
[Fig. 2] Fig. 2 is a part of a sectional view taken along line A-A of Fig. 1.
[Fig. 3] Fig. 3 is a schematic of thermally expanded states of a supporting member and a to-be-contacted member when the temperature is rising.
[Fig. 4A] Fig. 4A is a diagram of a manufacturing step of an electrically conductive contact holder constituting an electrically conductive contact unit;
[Fig. 4B] Fig. 4B is a diagram of a manufacturing step of the electrically conductive contact holder constituting an electrically conductive contact unit;
[Fig. 4C] Fig. 4C is a diagram of a manufacturing step of the electrically conductive contact holder constituting an electrically conductive contact unit;
[Fig. 5] Fig. 5 is a detailed schematic view of an inner wall of an opening formed in a supporting member;
[Fig. 6] Fig. 6 is a sectional view of a structure of an electrically conductive contact holder according to a modified embodiment;
[Fig. 7] Fig. 7 is a sectional view of a structure of an electrically conductive contact holder according to another modified embodiment; and
[Fig. 8] Fig. 8 is a sectional view of a structure of a conventional electrically conductive contact unit.

### EXPLANATIONS OF LETTERS OR NUMERALS

- 1: electrically conductive contact holder
- 2: electrically conductive contact
- 3: circuit board
- 4: supporting member
- 4a: opening
- 5: holder hole forming unit
- 6: holder hole
- 6a: small diameter hole
- 6b: large diameter hole
- 8: to-be-contacted member
- 9: external connecting terminal
- 10: spring member
- 10a: tight wound unit
- 10b: loose wound unit
- 11: needle-shaped member
- 11a: needle-shaped portion
- 11b: boss portion
- 11c: axial portion
- 12: needle-shaped member 12
- 12a: needle-shaped portion
- 12b: flange portion
- 12c: boss portion
- 13: electrode
- 15, 18: low thermal expansion supporting frame
- 16, 17: high thermal expansion supporting frame
- 16a: opening
- 19: insulating film
- 20: resist pattern
- 21: ceramic material
- 22: foil member
- 24: supporting member
- 25: holder base plate
- 26, 29: low thermal expansion supporting frame
- 27, 28: high thermal expansion supporting frame
- 31: holder hole forming unit 31
- 32, 35: low thermal expansion supporting frame
- 33, 34: high thermal expansion supporting frame
- 36: supporting member
- 101: holder base plate
- 102: holder hole forming unit
- 103: holder hole
- 104: electrically conductive contact
- 105: electrode
- 106: circuit board
- 107: 8 to-be-contacted member
- 108: external connecting terminal

### BEST MODE(S) FOR CARRYING OUT THE INVENTION

Best modes (hereinafter, "embodiment(s)") for carrying out the present invention to provide an electrically conductive unit to which is applied an electrically conductive contact holder will be explained in detail with reference to the accompanying drawings. It should be noted that the figures are illustrative only, and the relationship between a thickness and a width in each portion or part and the ratios of the thicknesses of respective portions are different from those in an actual product. Relationships or ratios in size may be different among respective figures.

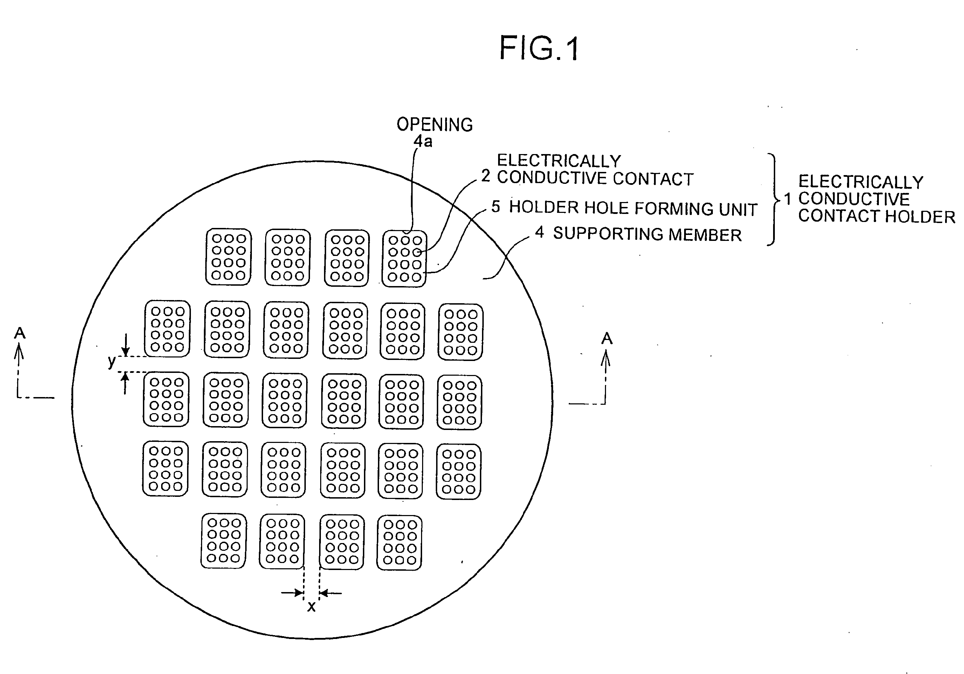

The electrically conductive contact unit according to the embodiment includes a supporting member formed by stacking a high thermal expansion supporting frame with a coefficient of linear expansion higher than that of a to-be-contacted member and a low thermal expansion supporting frame with a coefficient of linear expansion lower than that of the to-be-contacted member together. Fig. 1 is a plan view of the electrically conductive contact unit according to the embodiment. The electrically conductive contact unit according to the embodiment includes an electrically conductive contact holder 1, electrically conductive contacts 2 accommodated in the electrically conductive contact holder, and a circuit board 3 (not shown in Fig. 1) arranged on a lower layer of the electrically conductive contact holder 1. The electrically conductive contact holder 1 is provided with a supporting member 4, where a plurality of openings 4a are formed at x spacing in the horizontal direction of Fig. 1 and at y spacing in the vertical direction, and holder hole forming units 5 set in the openings 4a, respectively. In each holder hole forming unit 5, holder holes 6 (not shown in Fig. 1) are formed to accommodate the electrically conductive contacts 2.

The electrically conductive contact unit according to the embodiment is formed assuming that the to-be-contacted member, which is an inspection subject, is a semiconductor wafer, and it has a structure corresponding to a semiconductor wafer regarding the arrangements of the holder hole forming units 5 and the electrically conductive contacts 2. Specifically, a semiconductor wafer has a disc shape, and many semiconductor devices are formed on its surface. On an 8-inch semiconductor wafer (a diameter of about 200 millimeters) or a 12-inch wafer (a diameter of about 300 millimeters), several hundreds to several tens of thousands semiconductor devices are formed. Therefore, in the electrically conductive contact holder 1 in this embodiment, the holder hole forming units 5 are arranged to correspond to an arrangement pattern of semiconductor devices on a semiconductor wafer, and the holder holes are formed at positions corresponding to external connecting terminals provided on the individual semiconductor device to accommodate the electrically conductive contacts 2.

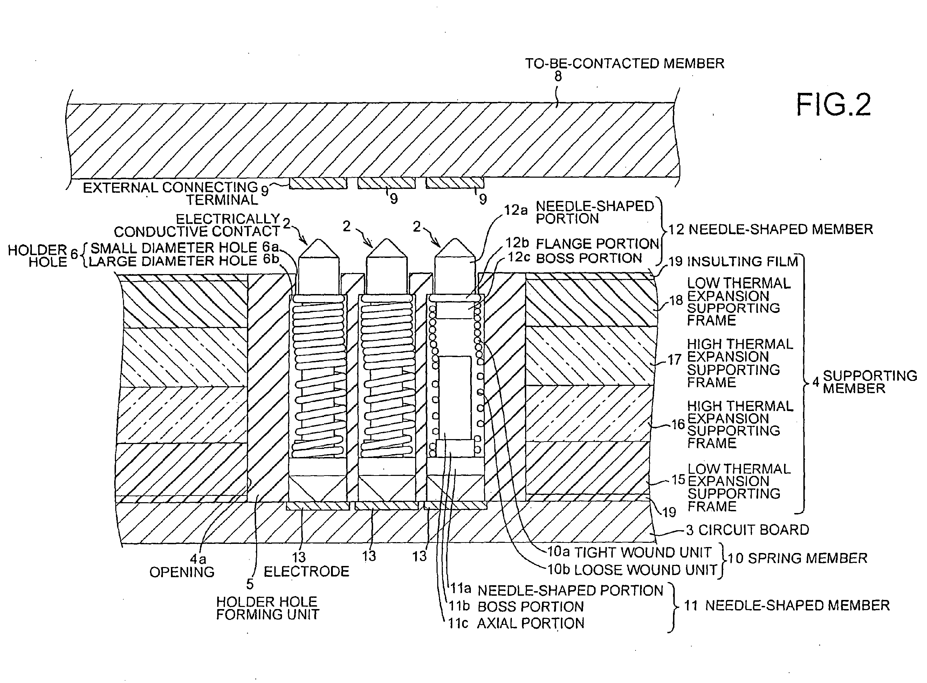

Fig. 2 is a part of a sectional view taken along line A-A of Fig. 1. In Fig. 2, a to-be-contacted member 8 is also shown for reference. As shown in Fig. 2, in the electrically conductive contact unit according to the embodiment, the supporting member 4 and the holder hole forming unit 5 are arranged on the circuit board 3, and the holder hole 6 is formed at a position corresponding to each of external connecting terminals 9 provided on the to-be-contacted member 8. The electrically conductive contacts 2 are accommodated in the holder holes 6 so as to partially protrude from a contacting surface opposed to the to-be-contacted member 8.

Each of the electrically conductive contact 2 includes a spring member 10 formed of an electrically conductive coil spring and a pair of needle-shaped members 11 and 12 disposed at both ends of the spring member 10 and formed such that their distal ends are arranged in directions opposite to each other. Particularly, the needle-shaped member 11 is disposed on the side of the circuit board 3 (the lower side in Fig. 2) from the spring member 10, while the needle-shaped member 12 is disposed on the side of the to-be-contacted member 8 (the upper side in Fig. 2) from the spring member 10.

The needle-shaped member 11 is formed of an electrically conductive material, and includes a needle-shaped portion 11a with a tapered end directed downwardly, a boss portion 11b on the needle-shaped portion 11a having a diameter smaller than that of the needle-shaped portion 11a, and an axial portion 11c on the boss portion 11b, which are formed coaxially. On the other hand, the needle-shaped member 12 includes a needle-shaped portion 12a with a tapered end directed upwardly, a flange portion 12b under the needle-shaped portion 12a having a diameter larger than that of the needle-shaped portion 12a, and a boss portion 12c under the flange portion 12b, which are formed coaxially.

The spring member 10 includes a tight wound unit 10a formed on the upper side in Fig. 2 and a loose wound unit 10b on the lower side. An end portion of the tight wound unit 10a is wound on the boss portion 12c of the needle-shaped member 12, and an end portion of the loose wound unit 10b is wound on the boss portion 11b of the needle-shaped portion 11a. The tight wound unit 10a and the boss portion 12c, and the loose wound unit 10b and the boss portion 11b are joined by the winding force of the spring and/or soldering. By providing the electrically conductive contact 2 with the spring member 10, the needle-shaped members 11 and 12 can be resiliently moved in the vertical direction, and the needle-shaped members 11 and 12 are electrically connected to each other. With the above structure, the electrically conductive contact 2 can be resiliently connected to the external connecting terminal 9 and an electrode 13 to establish an electrical connection therebetween.

The circuit board 3 includes an electronic circuit (not shown) that generates an electric signal or the like supplied to the to-be-contacted member 8 such as a semiconductor wafer or the like. An electric signal generated by the electronic circuit is supplied to a semiconductor device(s) within the to-be-contacted member 8 via the electrode(s) 13, the electrically conductive contact(s) 2 and the external connecting terminal(s) 9.

In the holder hole forming unit 5 are formed the holder holes 6 to accommodate the electrically conductive contacts 2. Specifically, the holder hole forming unit 5 is set in the opening 4a formed in the supporting member 4, and has a structure in which the holder holes 6 are formed to correspond to the arrangement of the external connecting terminals provided on the to-be-contacted member 8. In order to realize the structure, the holder hole forming unit 5 is formed of a material in which holes can be created easily. For example, ceramic is used in this embodiment. Other materials than ceramic can be used for forming the holder hole forming unit 5. For example, it is possible to form the holder hole forming unit 5 using a resin such as Sumikasuper (Trademark), which is a wholly aromatic polyester. When formed of resin, the holder hole forming unit 5 can be set in the opening 4a as when formed of ceramic, or formed by pouring liquid insulating resin into the opening 4a and then solidifying it.

The holder hole 6 has a stepped hole shape where a small diameter hole 6a at the upper end portion and a large diameter hole 6b at the remaining portion are formed coaxially. The small diameter hole 6a is formed such that the inner diameter is larger than the outer diameter of the needle-shaped portion 12a of the needle-shaped member 12 and is smaller than the outer diameter of the flange portion 12b. Since the holder hole 6 is formed in a stepped hole shape, the needle-shaped member 12 constituting the electrically conductive contact 2 is prevented from coming off from the holder hole 6 in the upward direction.

The supporting member 4 will be explained next. The supporting member 4 in this embodiment reinforces the strength of the electrically conductive contact holder 1. As also shown in Fig. 1, the supporting member 4 occupies the most part of the electrically conductive contact holder 1, and functions as a base material for the electrically conductive contact holder 1. In this embodiment, while maintaining such a function, the supporting member 4 prevents displacement between the external connecting terminal 9 and the electrically conductive contact 2 even under temperature conditions other than room temperature, such as at high temperatures. A structure and advantages of the supporting member 4 will be explained below.

As shown in Fig. 2, the supporting member 4 has a structure in which a plurality of members are stacked in a direction perpendicular to the contacting surface (a vertical direction in Fig. 2, hereinafter, "thickness direction"). Specifically, the supporting member 4 includes a low thermal expansion supporting frame 15, high thermal expansion supporting frames 16 and 17, and a low thermal expansion supporting frame 18, which are sequentially stacked in layers, and an insulating film 19 formed on the outer surface. Because the insulating film 19 is formed to be thinner than each supporting frame such as the low thermal expansion supporting frame 15, thermal expansion described later is negligible.

The supporting member 4 has the opening 4a formed to penetrate the low thermal expansion supporting frames 15, the high thermal expansion supporting frames 16 and 17, and the low thermal expansion supporting frame 18. The opening 4a can be formed by such methods as punching, laser ablation, electron beam irradiation, ion beam irradiation, wire electric discharge machining, press working, and wire cutting. In this embodiment, the opening 4a is formed by etching, as described later.

The low thermal expansion supporting frames 15 and 18 are formed of materials with the same coefficient of linear expansion, and have the same thickness. The coefficient of linear expansion of each of the low thermal expansion supporting frames 15 and 18 is lower than the coefficient of linear expansion of the to-be-contacted member 8, i.e., a coefficient of linear expansion of silicon as a base material when the to-be-contacted member 8 is, for example, a semiconductor wafer. Similarly, the high thermal expansion supporting frames 16 and 17 are formed of materials with the same coefficient of linear expansion, and have the same thickness. The coefficient of linear expansion of each of the high thermal expansion supporting frames 16 and 17 is higher than the coefficient of linear expansion of the to-be-contacted member 8. As far as the conditions are satisfied, each of the low thermal expansion supporting frames 15 and 18 and the high thermal expansion supporting frames 16 and 17 can be formed of any material. However, considering strength support function required for the supporting member 4 and the facilitation of the process, it is preferable that each supporting frame be formed of a metal material or a resin material.

As also shown in Fig. 2, the supporting member 4 has a structure that the low thermal expansion supporting frame 15 and 18 and the high thermal expansion supporting frames 16 and 17 are stacked symmetrically about the midplane (an interface between the high thermal expansion supporting frames 16 and 17) in the thickness direction. The order in which the low thermal expansion supporting frames 15 and 18 and the high thermal expansion supporting frames 16 and 17 are stacked is not necessarily limited to that shown in Fig. 2. However, the layers are stacked preferably so that the distribution of the coefficients of linear expansion is symmetrical about at least the midplane in order to prevent warping of the supporting member 4, as described later.

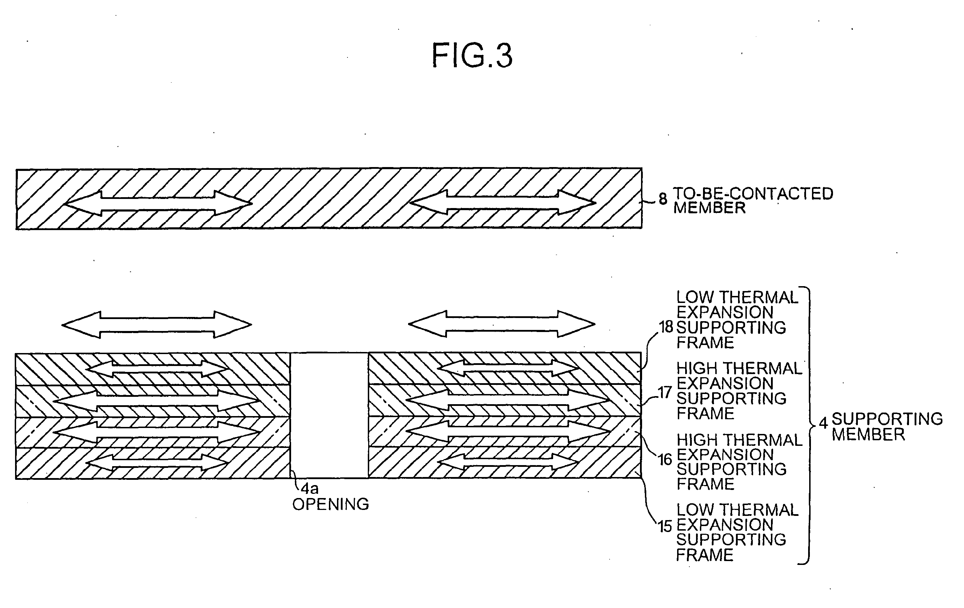

Advantages of the above structure of the supporting member 4 will be explained next. Fig. 3 is a schematic for explaining advantages when an inspection or the like is performed on the to-be-contacted member 8 under a high temperature condition. For the sake of understanding, the electrically conductive contacts 2, the circuit board 3, and the holder hole forming unit 5 are not shown in Fig. 3. Sizes of arrows shown in Fig. 3 indicate degrees of expansion of respective members due to temperature rise.

As shown in Fig. 3, the supporting member 4 and the to-be-contacted member 8 are expanded or inflated in a direction parallel to the contacting surface (in the horizontal direction in Fig. 3) according to the respective coefficients of linear expansion when they are exposed to a high temperature condition. The low thermal expansion supporting frames 15 and 18 constituting the supporting member 4 have a coefficient of linear expansion lower than that of the to-be-contacted member 8, and expand less than the to-be-contacted member 8. On the other hand, the high thermal expansion supporting frames 16 and 17 have a coefficient of linear expansion higher than that of the to-be-contacted member 8, and expand more than the to-be-contacted member 8. Accordingly, when the supporting member 4 is formed of only the low thermal expansion supporting frames 15 and 18 or the high thermal expansion supporting frames 16 and 17, displacement occurs between the external connecting terminals 9 on the to-be-contacted member 8 and the electrically conductive contacts 2 of the electrically conductive contact unit during an inspection or the like under a high temperature condition, which obstructs the inspection.

On the other hand, in this embodiment, the supporting member 4 is formed by stacking the low thermal expansion supporting frames 15 and 18 and the high thermal expansion supporting frames 16 and 17 in layers, with one applying stress to another, so that it is possible to reduce the difference in coefficient of linear expansion between the to-be-contacted member 8 and the supporting member 4. That is, the high thermal expansion supporting frames 16 and 17 are subjected to stress from the low thermal expansion supporting frames 15 and 18 in the compression direction due to the difference in coefficient of linear expansion between the both. Therefore, the degree of thermal expansion of the supporting member 4 approximates to that of the to-be-contacted member 8 as compared with the case that the supporting member 4 is formed of a single frame. Besides, the low thermal expansion supporting frames 15 and 18 are subjected to stress from the high thermal expansion supporting frames 16 and 17 in the elongation direction. Therefore, the degree of thermal expansion of the supporting member 4 further approximates to that of the to-be-contacted member 8 as compared with the case that the supporting member 4 is formed of a single frame. In other words, by laminating the high thermal expansion supporting frames 16 and 17 and the low thermal expansion supporting frames 15 and 18, the coefficient of linear expansion of the entire supporting member 4 can be approximated to that of the to-be-contacted member 8. Accordingly, the electrically conductive contact unit according to the embodiment can reduce the occurrence of displacement due to a temperature change, as compared with the case that the supporting member is formed of, for example, a single high thermal expansion supporting frame.

In order to adjust the coefficient of linear expansion of the supporting member 4 to that of the to-be-contacted member 8 more accurately, it is preferable that values of the thickness and the coefficient of linear expansion in one of the low thermal expansion supporting frames 15 and 18 and the high thermal expansion supporting frames 16 and 17 be adjusted based upon those in the other. For example, when the coefficient of linear expansion of the to-be-contacted member 8 is 3.44×10⁻⁶ (/°C), preferablely, the low thermal expansion supporting frames 15 and 18 are formed of Invar, while the high thermal expansion supporting frames 16 and 17 are formed of Kovar (Trademark). Specifically, for the low thermal expansion supporting frames 15 and 18, Invar with a coefficient of linear expansion of 2.0x10⁻⁶ (/°C) having a Young's modulus of about 1,490N/mm² is used. For the high thermal expansion supporting frames 16 and 17, Kovar with a coefficient of linear expansion of 4.5x10⁻⁶ (/°C) having a Young's modulus of 2,040 N/mm2 is used. In addition, if the thickness of each supporting frame is set to 0.5 millimeters, then the supporting member 4 with a coefficient of linear expansion of 3.44x10-6 (/°C) can be obtained.

As a metal material for forming the low thermal expansion supporting frames 15 and 18, it is also possible to use Super-Invar. The Super-Invar is a metal alloy with a coefficient of linear expansion of about 0.5x10-6 (/°C) having a Young's modulus of about 1,490N/mm2. Because of the very low coefficient of linear expansion, the Super-Invar is suitably used as a metal material for forming the low thermal expansion supporting frames 15 and 18.

The expression "adjust the coefficient of linear expansion of the supporting member 4 to that of the to-be-contacted member 8" does not always mean that the coefficients of linear expansion of the both are caused to completely coincide with each other. That is, the both can be regarded as a "match" even if there is a slight difference between them to such an extent that no interference is caused in electric connection between the external connecting terminals 9 on the to-be-contacted member 8 and the electrically conductive contacts 2 accommodated in the electrically conductive contact holder 1. It is unnecessary to adjust the coefficient of linear expansion under all temperature conditions, and it suffices to achieve a match under a temperature condition where the electrically conductive contact unit is used. For example, an acceleration test is performed under temperature conditions such as 40°C, 85°C to 95°C, 125°C, or 150°C, and the advantages of the present invention can be achieved by adjusting the coefficients of linear expansion such that the degrees of expansion match under at least one of these temperature conditions.

In the electrically conductive contact unit according to the embodiment, the supporting member 4 is formed such that the distribution of the coefficients of linear expansion of the respective supporting frames is symmetrical about the midplane in the thickness direction. Thus, warping of the supporting member 4 can be prevented under high temperature conditions. Specifically, because the degree of thermal expansion on the upper side of the midplane is substantially equal to that on the lower side, stress acting on the supporting member 4 is balanced in the thickness direction. Therefore, it is possible to prevent warping of the supporting member 4.

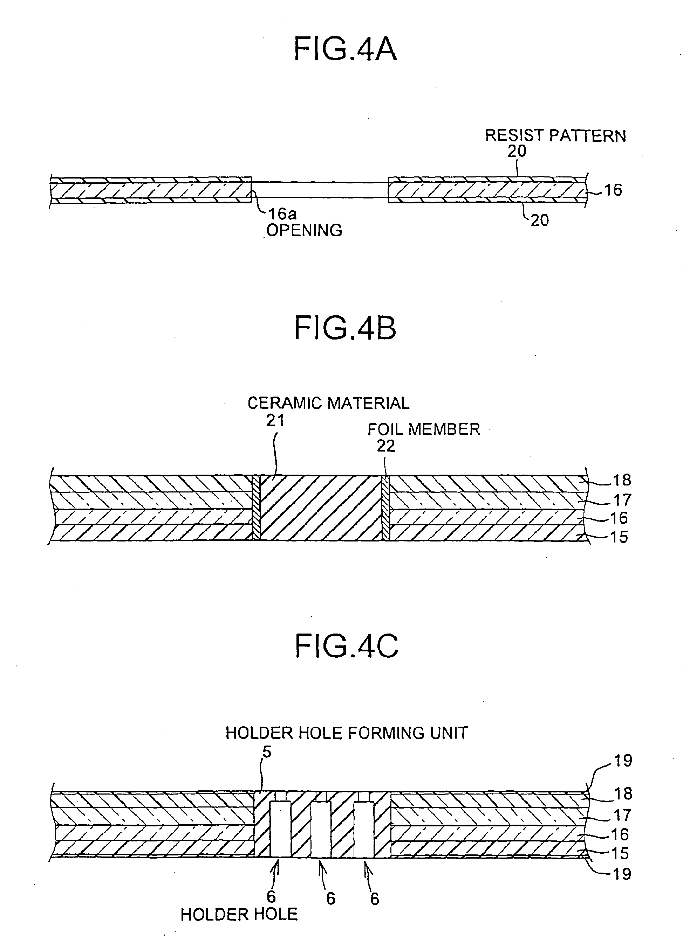

A method for manufacturing the electrically conductive contact holder 1 constituting the electrically conductive contact unit according to the embodiment will be explained next. Figs. 4A to 4C are schematic views of manufacturing steps of the electrically conductive contact holder 1. The following explanation is given with reference to Figs. 4A to 4C.

Predetermined openings are first formed in respective members constituting the supporting member 4. Specifically, as shown in Fig. 4A, a predetermined resist pattern 20 is formed on the high thermal expansion supporting frame 16 and an opening 16a corresponding to the opening 4a is formed by etching. After the etching is completed, the resist pattern 20 is removed. Although Fig. 4A depicts only the high thermal expansion supporting frame 16 as an example, the same process is used to form openings corresponding to the opening 4a in the low thermal expansion supporting frames 15 and 18, and the high thermal expansion supporting frame 17.

As shown in Fig. 4B, the low thermal expansion supporting frame 15, the high thermal expansion supporting frames 16 and 17, and the low thermal expansion supporting frame 18 in which the openings have been formed, respectively, are stacked sequentially, and a ceramic material 21 with a foil member 22 wound thereon is inserted into the openings. The foil member 22 acts as a solder material. For example, a silver solder formed in a foil can be used as the foil member 22. Having been set as shown in Fig. 4B, the ceramic material 21 is applied with a predetermined pressure and is heated up to a predetermined temperature of 800°C or more. Accordingly, the interfaces between the respective supporting frames are joined together by diffusion bonding, and the ceramic material 21 and the frame members, such as the low thermal expansion supporting frame 15, are soldered together due to melting of the foil member 22. Fixing material for the holder hole forming unit 6 is not limited to the silver solder or the like, and an ordinary adhesive can be used.

Finally, as shown in Fig. 4C, the holder hole forming unit 5 is formed by forming the holder holes 6 in the ceramic material 21. Specifically, after the step shown in Fig. 4B, the outer surface of the supporting member 4 is planarized if necessary, and the insulating film 19 is formed on the outer surface. By applying a predetermined process or treatment to the ceramic material 21, the holder hole forming unit 5 is formed, and thereby the electrically conductive contact holder 1 is produced. The manufacture of the electrically conductive contact holder 1 is completed through the steps shown in Figs. 4A to 4C. Thereafter, the electrically conductive contacts 2 are accommodated in the holder holes 6, and the electrically conductive contact holder 1 is fixed to the circuit board 3. Thereby, the electrically conductive contact unit according to this embodiment is completed.

In this embodiment, as shown in Figs. 4A and 4B, after the openings are formed in respective supporting frames by etching, the respective supporting frames are joined together by diffusion bonding. The openings can be formed after the supporting frames are joined together. However, the following advantages can be obtained by forming an opening for each supporting frame.

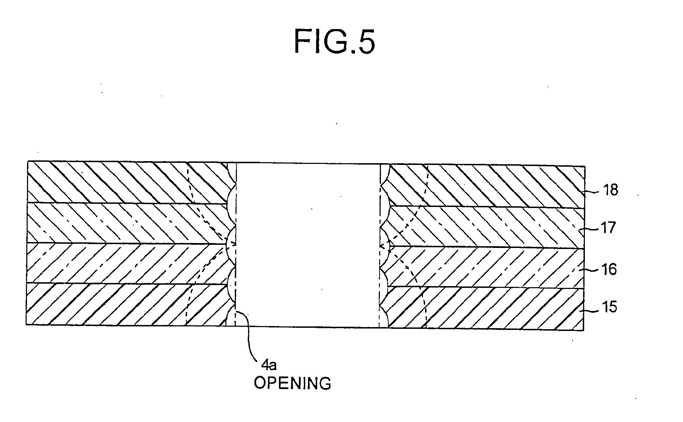

Fig. 5 is a detailed schematic view of an inner wall of the opening formed with respect to each supporting frame. In Fig. 5, a boundary indicated with an alternate long and short dash line represents an inner wall of the opening 4a in design, and a boundary indicated with a broken line represents an inner wall of an opening formed by etching after the respective supporting frames are joined together.

When an opening is formed by etching, so-called side etching, i.e., etching that proceeds not only in the thickness direction of material to be etched but also in a direction perpendicular to the thickness direction, is induced. Because such side etching proceeds according to the etching time, the amount of side etching increases as the material to be etched becomes thicker. For example, when openings are formed after the respective supporting frames are joined together, the amount of side etching increases to the extent indicated by the broken lines in Fig. 5. Consequently, it becomes difficult to control the size of the opening.

For this reason, in this embodiment, before the respective supporting frames are jointed together, the respective openings are formed therein, so that the time required for etching is reduced. That is, by forming the openings according to the thicknesses of the respective supporting frames not having been joined, it is possible to reduce the etching time and the amount of side etching. Accordingly, the difference between the inner wall of the opening 4a actually formed and the inner wall of the opening in design is slight, and therefore, the size of the opening 4a can be controlled easily.

In this embodiment, as shown in Fig. 4B, diffusion bonding between the respective supporting frames and soldering of the ceramic material 21 are performed simultaneously. This is because temperature required for the diffusion bonding is about 800°C or more, and such temperature satisfies the temperature condition for soldering in this embodiment. By performing the diffusion bonding and the soldering simultaneously, it is possible to reduce the number of steps required for manufacturing the electrically conductive contact holder 1. Thus, the electrically conductive contact holder 1 can be manufactured at low cost.

The above advantages in the manufacturing steps can be achieved regardless of the coefficient of linear expansion of each supporting frame constituting the supporting member 4. Accordingly, the manufacturing method shown in Figs. 4A to 4C can be used for an electrically conductive contact holder having a supporting member with a laminated structure of a plurality of plate members and an electrically conductive contact unit in general.

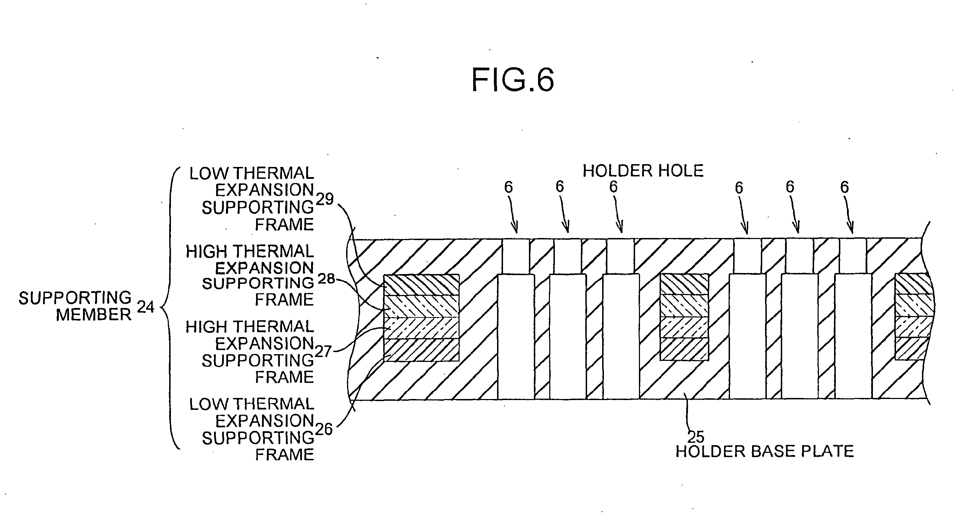

A modification of the embodiment will be explained next. Fig. 6 is a view of an electrically conductive contact holder constituting an electrically conductive contact unit according to the modified embodiment. As shown in Fig. 6, in this modified embodiment, an electrically conductive contact holder includes as base material a holder base plate 25 made of a material in which an opening is easily formed, while a supporting member 24 is arranged in the holder base plate 25.

The supporting member 24 includes a low thermal expansion supporting frame 26, high thermal expansion supporting frames 27 and 28, and a low thermal expansion supporting frame 29, which are sequentially laminated. By adjusting coefficients of linear expansion and thicknesses of the supporting frames, displacement from the to-be-contacted member 8 is suppressed at high temperatures. Even when the supporting member 24 is set in the holder base plate 25 as a reinforcing member, it is possible to realize an electrically conductive contact unit that can be used under high temperature conditions by adjusting the coefficient of linear expansion of the entire supporting member 24 to that of the to-be-contacted member 8.

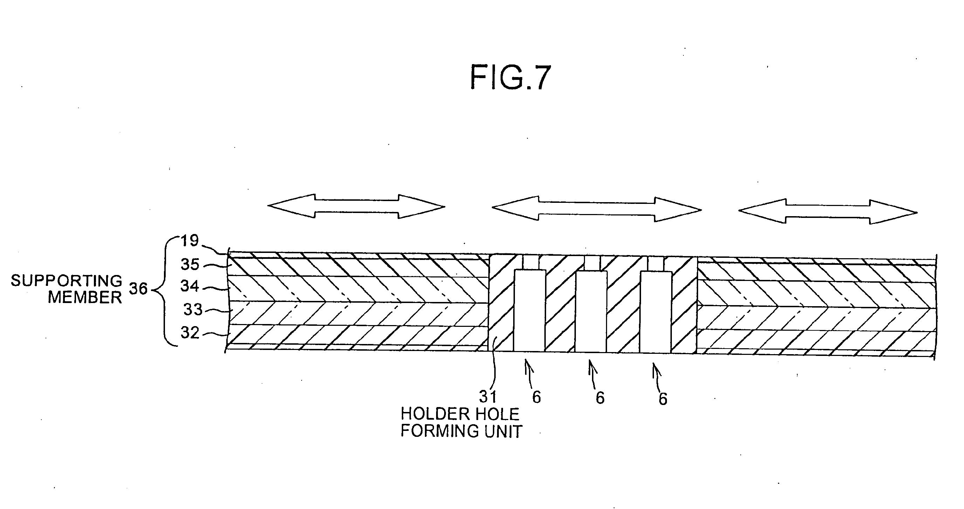

Instead of adjusting the coefficient of linear expansion of only the supporting member to that of the to-be-contacted member, it is also possible to adjust the coefficient of linear expansion of the supporting member integrated with the holder hole forming unit to that of the to-be-contacted member 8. Fig. 7 is a schematic view of a structure of an electrically conductive contact holder according to such a modified embodiment.

In this modified embodiment shown in Fig. 7, an electrically conductive contact holder includes a supporting member 36 having a laminated structure of a low thermal expansion supporting frame 32, high thermal expansion supporting frames 33 and 34, and a low thermal expansion supporting frame 35, with a coefficient of linear expansion lower than that of the to-be-contacted member 8 as a whole, and a holder hole forming unit 31 that is set in an opening formed in the supporting member 36 and has a coefficient of linear expansion higher than that of the to-be-contacted member 8. That is, in this modified embodiment, instead of adjusting the coefficient of linear expansion of the supporting member 36 to that of the to-be-contacted member 8, a coefficient of linear expansion of the supporting member 36 integrated with the holder hole forming unit 31 is adjusted to that of the to-be-contacted member 8.

The holder hole forming unit 31 is used for forming holder holes 6 that accommodates electrically conductive contacts 2, and needs to be made of a material satisfying conditions such as being easily processed. There is no problem if a coefficient of linear expansion of material used for the holder hole forming unit 31 completely coincides with that of the to-be-contacted member 8. However, in practice, it is difficult to cause the both to completely match each other, and a slight difference may exist between them. Especially, the slight difference in coefficient of linear expansion between the holder hole forming unit 31 and the to-be-contacted member 8 causes a problem when the to-be-contacted member 8 includes many semiconductor devices, such as a semiconductor wafer, and the electrically conductive contact holder has a structure where many holder hole forming unit 31 are arranged to correspond to respective semiconductor devices. That is, even if displacement due to each holder hole forming unit 31 is within an allowable range, displacement may be produced near the periphery of a contacting surface opposed to the to-be-contacted member 8 to such an extent that an inspection is impossible when displacements caused by many holder hole forming unit 31 are superimposed.

Therefore, in this modified embodiment, in order to reduce displacement due to the difference in coefficient of linear expansion between the holder hole forming unit 31 and the to-be-contacted member 8, the coefficient of linear expansion of the supporting member 36 is adjusted. Specifically, in this modified embodiment, when the coefficient of linear expansion of the holder hole forming unit 31 is higher than that of the to-be-contacted member 8, the coefficient of linear expansion of the supporting member 36 is made lower than that of the to-be-contacted member 8 by adjusting the coefficient of linear expansion and the thickness of such a supporting frame as the low thermal expansion supporting frame 32. With this structure, even if an allowable level of displacement occurs in each of the holder hole forming units 31, the displacement is reduced by the supporting member 36. Thus, it is possible to prevent displacements from being superimposed to the extent that the electrically conductive contact holder is unusable at the periphery.

For example, as the material used for the holder hole forming unit 31, a ceramic having a coefficient of linear expansion of 9.8×10⁻⁶ (/°C) , 7.8x10⁻⁶ (/°C), or 1.4x10⁻⁶ (/°C) or the like can be used. Sumikasuper explained in the first embodiment has a coefficient of linear expansion of 5.1x10⁻⁶ (/°C). The coefficients of linear expansion of these ceramics do not always match that of the to-be-contacted member 8. Therefore, by selecting suitable materials and adjusting the thickness for the low thermal expansion supporting frames 32 and 35 and the high thermal expansion supporting frames 33 and 34, respectively, it is possible to adjust the coefficient of linear expansion of the whole of the supporting member 36 and the holder hole forming unit 31 to that of the to-be-contacted member 8.

Incidentally, in the modified embodiment, the coefficient of linear expansion of the supporting member 36 is adjusted according to that of the holder hole forming unit 31. However, the coefficient of linear expansion of the holder hole forming unit 31 can be adjusted according to that of the supporting member 36. Besides, the coefficient of linear expansion of the holder hole forming unit 31 can be made lower than that of the to-be-contacted member 8, and the coefficient of linear expansion of the supporting member 36 can be made higher than that of the to-be-contacted member 8. Further, the supporting member 36 can be constituted of a single plate instead of the low thermal expansion supporting frames and the high thermal expansion supporting frames in the laminated structure.

While the present invention have been described above in connection with an embodiment and modified embodiments, it is to be understood that the invention is not limited to the embodiments, and it will be apparent to those skilled in the art that various modifications and variations can be made therein. For example, as shown in Figs. 4A to 4C, the supporting member 4 is formed in such a manner that the low thermal expansion supporting frames 15 and 18 and the high thermal expansion supporting frames 16 and 17 are formed with the openings 16a or the like in advance, and thereafter, joined together according to an embodiment of the present invention. However, the manufacturing method of the supporting member 4 is not limited to this. It is also possible, for example, to form the openings 4a at one time by wire cutting after the low thermal expansion supporting frames 15 and 18 and the high thermal expansion supporting frames 16 and 17 are joined together. By adopting such a manufacturing method, it is possible to spare the trouble of aligning the openings formed in the low thermal expansion supporting frames 15 and 18 and the high thermal expansion supporting frames 16 and 17, respectively. In particular, when a supporting member is formed, which includes the openings 4a with a spacing (x, y in Fig. 1) of 2 millimeters or less, especially about 1 to 1.5 millimeters or less between one another, it is necessary to align openings with high precision for joining supporting frames together after the openings are formed in the respective supporting frames. Therefore, it is remarkably useful to form the openings 4a at one time after the supporting frames are joined together.

### INDUSTRIAL APPLICABILITY

As set forth hereinabove, an electrically conductive contact holder, an electrically conductive contact unit, and a method for manufacturing the electrically conductive contact holder according to the present invention can be suitably applied to a device used to test a to-be-contacted member such as a semiconductor integrated circuit (IC).

## Claims

1. An electrically conductive contact holder comprises a supporting member to hold a plurality of electrically conductive contacts, with a contacting surface corresponding to a terminal surface of a to-be-contacted member, on which a plurality of external connecting terminals are arranged, the electrically conductive contacts being arranged on the contacting surface so as to be electrically connected to the external connecting terminals, and being accommodated in holder holes, wherein the supporting member includes
a high thermal expansion supporting frame with a coefficient of linear expansion higher than that of the to-be-contacted member; and
a low thermal expansion supporting frame that is arranged adjacent to the high thermal expansion supporting frame in a direction normal to the contacting surface, and has a coefficient of linear expansion lower than that of the to-be-contacted member.

2. The electrically conductive contact holder according to claim 1, wherein the high thermal expansion supporting frame and the low thermal expansion supporting frame are formed so that a coefficient of linear expansion of the supporting member, defined based upon the thickness in the normal direction and the coefficient of linear expansion of each of the high thermal expansion supporting frame and the low thermal expansion supporting frame, corresponds to the coefficient of linear expansion of the to-be-contacted member.

3. The electrically conductive contact holder according to claim 1, wherein the supporting member is formed such that the distribution of the coefficient of linear expansion thereof in the normal direction to the contacting surface is symmetrical about a midplane.

4. The electrically conductive contact holder according to claim 1, wherein the supporting member includes
an opening at a region where the electrically conductive contacts are arranged; and
a holder hole forming unit that is set in the opening to form the holder holes therein.

5. An electrically conductive contact holder comprising a supporting member, and an holder hole forming unit that is set in an opening formed in the supporting member and includes a holder hole accommodating an electrically conductive contact electrically connected to an external connecting terminal provided on a to-be-contacted member, wherein any one of the supporting member and the holder hole forming unit has a coefficient of linear expansion higher than that of the to-be-contacted member, while the other has a coefficient of linear expansion lower than that of the to-be-contacted member.

6. The electrically conductive contact holder according to claim 5, wherein the supporting member has a structure where a plurality of plate members having different coefficients of linear expansion are laminated in the thickness direction thereof.

7. An electrically conductive contact unit comprising:
electrically conductive contacts that are arranged on a contacting surface opposed to a to-be-contacted member so as to be electrically connected to external connecting terminals provided on the to-be-contacted member in use;
a supporting member that includes a high thermal expansion supporting frame with a coefficient of linear expansion higher than that of the to-be-contacted member and a low thermal expansion supporting frame that is arranged adjacent to the high thermal expansion supporting frame in a direction normal to the contacting surface and has a coefficient of linear expansion lower that that of the to-be-contacted member; and
a circuit board that is electrically connected to the electrically conductive contacts and generates an electric signal supplied to the to-be-contacted member.

8. The electrically conductive contact unit according to claim 7, wherein the high thermal expansion supporting frame and the low thermal expansion supporting frame are formed so that a coefficient of linear expansion of the supporting member, defined based upon the thickness in the normal direction of each of the high thermal expansion supporting frame and the low thermal expansion supporting frame and the coefficient of linear expansion thereof, corresponds to the coefficient of linear expansion of the to-be-contacted member , and that the distribution of the coefficient of linear expansion thereof in the normal direction to the contacting surface is symmetrical about a midplane.

9. An electrically conductive contact unit, comprising:
electrically conductive contacts that are arranged on a contacting surface opposed to a to-be-contacted member so as to be electrically connected to external connecting terminals provided on the to-be-contacted member in use;
a holder hole forming unit where holder holes are formed to accommodate the electrically conductive contacts;
a supporting member that supports the holder hole forming unit; and
a circuit board that is electrically connected to the electrically conductive contacts and generates an electric signal supplied to the to-be-contacted member, wherein
the holder hole forming unit and the supporting member are formed so that one thereof has a coefficient of linear expansion higher than that of the to-be-contacted member, while the other has a coefficient of linear expansion lower than that of the to-be-contacted member.

10. A method for manufacturing an electrically conductive contact holder including a supporting member formed by stacking a plurality of plate members in layers and a holder hole forming unit set in an opening formed in the supporting member, in which holder holes are formed to accommodate electrically conductive contacts that are electrically connected to external connecting terminals provided on a to-be-contacted member, the method comprising:
an opening forming step of forming openings in the respective plate members;
a supporting member forming step of joining the plurality of the plate members formed with the openings in the thickness direction of the plate members to form the supporting member;
a fixing step of fixing the holder hole forming unit to the inner surface of the opening of the supporting member formed; and
a holder hole forming step of forming the holder holes in the holder hole forming unit.

11. The method for manufacturing an electrically conductive contact holder according to claim 10, wherein the plate members are joined together by diffusion bonding, the holder hole forming unit is fixed by soldering, and the supporting member forming step and the fixing step are simultaneously conducted.
